# EUROPEAN PATENT APPLICATION

(11) **EP 2 348 553 A2**
(43) Date of publication of application: **27.07.2011**
(21) Application number: 10168424.9
(22) Date of filing: 05.07.2010
(51) Int. Cl.: H01L 33/64

(54) **Heat-dissipating device having a layered functional unit**

(30) Priority: 22.01.2010 TW 099101770
(71) Applicant: Luo, Chin-Kuang, Taichung City (TW)
(72) Inventor: Luo, Chin-Kuang, Taichung City (TW)
(74) Representative: Cohausz & Florack

(57) **Abstract**

A heat-dissipating device comprises a metallic layer (2) to contact a heat source (6), and a layered functional unit formed on the metallic layer (2) and including a semiconductor material and a far infrared material. Preferably, the functional unit further includes a carbon material having a large specific surface area. The heat from the metallic layer (6) excites the electrons in the semiconductor material to jump across band gap and then release heat energy, and excites the far infrared material to radiate far infrared rays. A rapid heat dissipation rate can be achieved by increasing heat transfer area and by converting heat into far infrared rays that can be radiated away rapidly.

## Description

The invention relates to a heat-dissipating device, more particularly to a heat-dissipating device having a layered functional unit.

Electronic devices, such as light emitting semiconductor chips, can generate considerable heat during their operations, which tends to affect adversely working performance and service life of the electronic devices. Therefore, heat-dissipating devices are needed to dissipate heat and to thereby maintain stable working performance for the electronic devices.

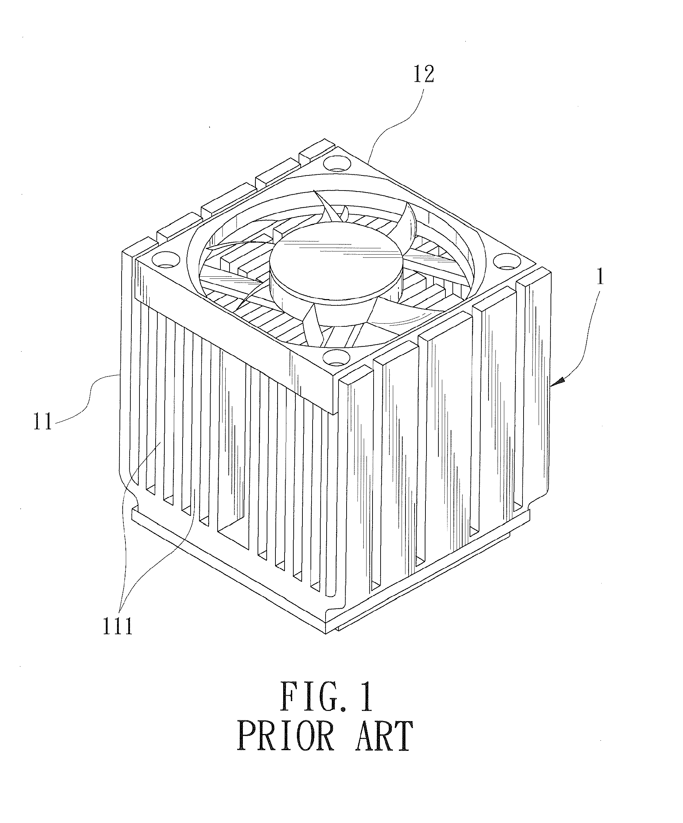

Referring to Fig. 1, a typical heat-dissipating device 1 includes a heat sink 11 to contact a heat source, and a fan 12 connected to the heat sink 11. The heat sink 11 is made of a highly heat-conductive metallic material such as copper or aluminum and has a multiplicity of parallel fins 111. In use, the heat sink 11 makes heat exchange with the heat source, and the fins 111 provides large heat transfer surface area for enhancement of heat-dissipation from the heat sink 11. The fan 12 serves to supply cold air to the fins 111 to accelerate heat-dissipation from the heat sink.

However, although the aluminum or copper heat sink 11 has a heat conductivity ranging from 200 to 480 w/ (m. k) which is sufficient for use as a heat exchange medium, the heat-dissipating effect of the heat sink 11 is inefficient due to the limited heat transfer surface area and the relatively slow heat-conduction rate thereof.

Therefore, the main object of the present invention is to provide a heat-dissipating device with a layered functional unit for enhancing heat-dissipating efficiency.

According to the present invention, a heat-dissipating device comprises: a metallic layer having a first surface, and a second surface adapted to contact a heat source; and a layered functional unit formed on the first surface for heat exchange with the metallic layer and including a semiconductor material capable of releasing heat energy upon thermal excitation, and a far infrared material capable of radiating far infrared rays upon thermal excitation.

Other features and advantages of the present invention will become apparent in the following detailed description of the preferred embodiments with reference to the accompanying drawings, of which:
Fig. 1 is a perspective view of the prior art;
Fig. 2 is a schematic view illustrating the first preferred embodiment of a heat-dissipating device according to the present invention; and
Fig. 3 is a schematic view illustrating the second preferred embodiment of a heat-dissipating device according to the present invention.

Before the present invention is described in greater-detail with reference to the accompanying preferred embodiment, it should be noted herein that like elements are denoted by the same reference numerals throughout the disclosure.

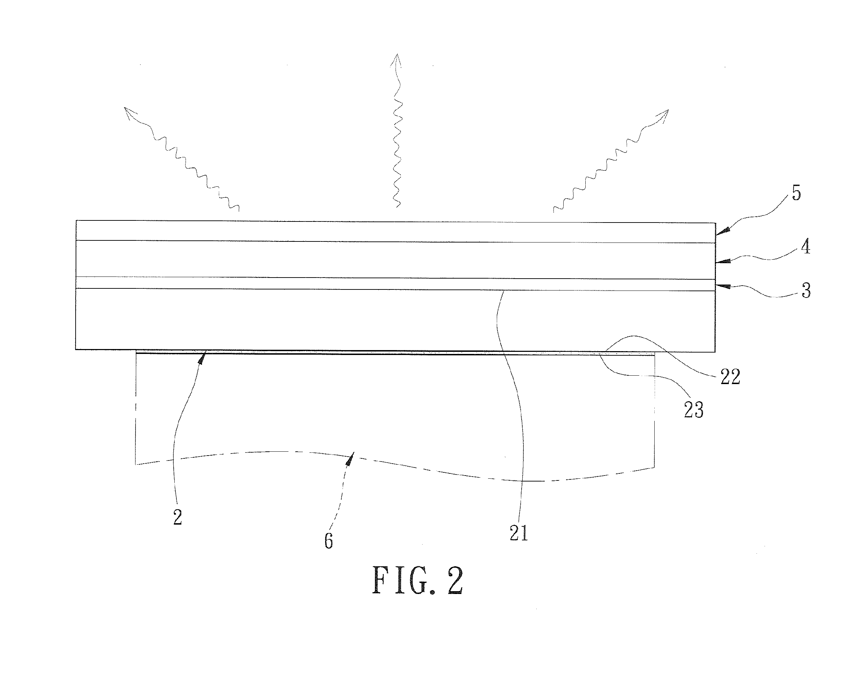

Referring to Fig. 2, the first preferred embodiment of the present invention includes a metallic layer 2 and a layered functional unit that includes a carbon material, a semiconductor material and a far infrared material. The carbon material, the semiconductor material and the far infrared material are formed as individual layers on the metallic layer 2, and are arranged in the order of the carbon material, the semiconductor material and the far infrared material from bottom to top. Particularly, the layered functional unit has a first layer 3 made from the carbon material, a second layer 4 made from the semiconductor material, and a third layer 5 made from of the far infrared material.

The metallic layer 2 has opposite first and second surfaces 21, 22. The second surface 22 is used to contact a heat source 6 and is formed with a layer of bonding material 23. The bonding material may be selected from the group consisting of a conductive adhesive, indium, indium tin, bismuth, lead, cadmium, an eutectic alloy and combinations thereof, and may be formed on the second surface 22 by immersion in the bonding material, or applying the bonding material to the metallic layer 2.

The first layer 3 of the carbon material is formed on the first surface 21 of the metallic layer 2. The carbon material may be selected from the group consisting of a diamond film, a diamond-like film, graphite and combinations thereof.

The second layer 4 of the semiconductor material is formed on the first layer 3. The semiconductor material may be selected from of the group consisting of bismuth telluride, lead telluride, boron carbide, silicon carbide, silicon germanium, silicon germanium carbide, and combination thereof.

The third layer 5 of the far infrared material is formed on the second layer 4. The far infrared material may include a far infrared ceramic. Preferably, the far infrared ceramic is a nano-sized far infrared ceramic powder which is mixed with a binder. The binder may include a resin. For example, the binder may be a mixture containing a resin and banana oil, or a mixture containing dehydrated alcohol and polyvinyl butyral.

In use, the metallic layer 2 is placed in contact with the heat source 6 to undergo a heat exchange process. The heat absorbed by the metallic layer 2 is transferred to the first layer 3 of the carbon material. As the carbon material has a large specific surface area, the heat transfer surface area can be increased to 150 times greater than the original surface area of the first surface 21 so that heat conductivity can be increased to more than 500w/(m.k). The rate of heat transfer can therefore be increased rapidly.

Thereafter, the heat from the first layer 3 is transferred to the second layer 4 of the semiconductor material. Due to thermal excitation, electrons in the semiconductor material jump across the band gap and then release energy. Depending on the type of the semiconductor material, the energy released from the semiconductor material may be in the form of heat, excited light, or a combination of heat and excited light. The excited light may be a short wavelength infrared ray.

Finally, the third layer 5 of the far infrared material is excited by the energy released from the second layer 4 and generates far infrared rays. Therefore, the heat transferred from the heat source 6 is eventually converted into far infrared rays which are radiated away from the heat source 6. Because the rate of radiation is faster than the rate of heat conduction, the overall heat-dissipating rate provided by the heat-dissipating device of the present invention is relatively faster than that of the prior art shown in Fig. 1.

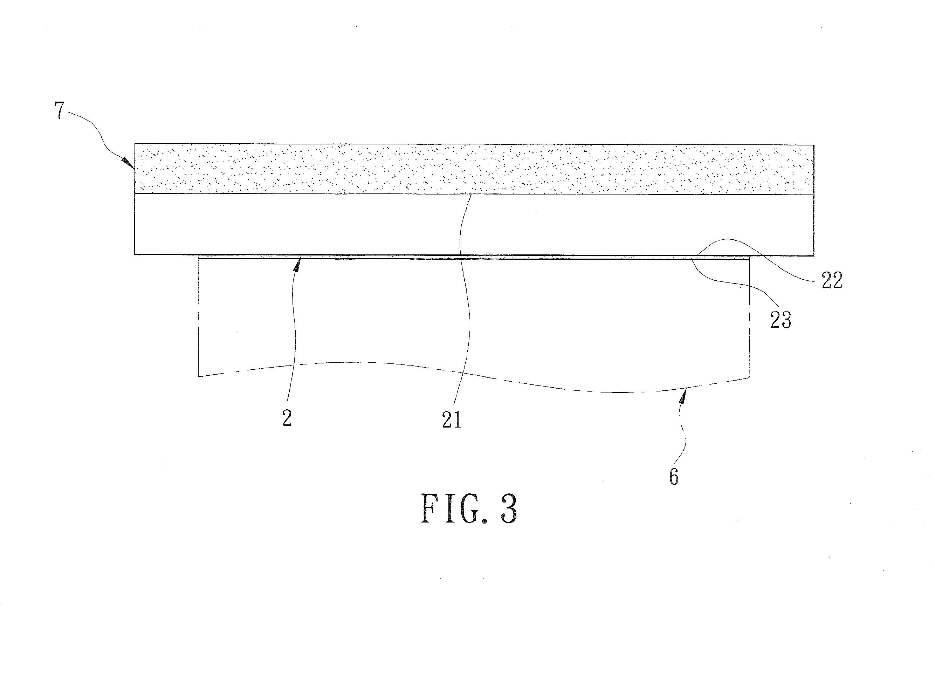

Referring to Fig. 3, there is shown the second preferred embodiment of the present invention which is generally similar to the first preferred embodiment. However, the layered functional unit in this embodiment includes a functional layer 7 made from the carbon material, the semiconductor material and the far infrared material which are mixed together in the presence of a binder. The resulting mixture is applied to the first surface 21 of the metallic layer 2.

The metallic layer 2 may be a layer of metal of a commercially available heat sink, and the mixture may be applied to the surface of the commercially available heat sink by dip coating or spray coating. After application to the heat sink, the mixture may be baked to form the functional layer 7. With the use of the mixture of the carbon material, the semiconductor material and the far infrared material, an efficient heat-dissipating effect can also be achieved in the second preferred embodiment.

The layered functional unit according to the present invention may further include a coloring agent to improve the appearance of the heat-dissipating device. In the first preferred embodiment, the first, second and third layers 3, 4 and 5 may include the same or different coloring agents. In the second preferred embodiment, the functional layer 7 may include one coloring agent.

## Claims

1. A heat-dissipating device **characterized, by**:
a metallic layer (2) having a first surface (21), and a second surface (22) adapted to contact a heat source (6); and
a layered functional unit formed on said first surface (21) for heat exchange with said metallic layer (2) and including a semiconductor material capable of releasing heat energy upon thermal excitation, and a far infrared material capable of radiating far infrared rays upon thermal excitation.

2. The heat-dissipating device of Claim 1, **characterized in that** the semiconductor material and the far infrared material are mixed together.

3. The heat-dissipating device of Claim 1, **characterized in that** the layered functional unit further includes a carbon material having a large specific surface area.

4. The heat-dissipating device of Claim 3, **characterized in that** the semiconductor material, the far infrared material, and the carbon material are mixed together.

5. The heat-dissipating device of Claim 4, **characterized in that** the carbon material, the semiconductor material, and the far infrared material are formed as individual layers (3,4,5) on said metallic layer (2) and are arranged **in that** order from bottom to top.

6. The heat-dissipating device of Claim 1, further **characterized by** a bonding material (23) disposed on said second surface (22) of said metallic layer (2) for bonding said metallic layer (2) to the heat source (6).

7. The heat-dissipating device of Claim 6, **characterized in that** the bonding material (23) is selected from the group consisting of a conductive adhesive, indium, indium-tin, bismuth, lead, cadmium, a eutectic alloy, and combinations thereof.

8. The heat-dissipating device of Claim 3, **characterized in that** the carbon material is selected from the group consisting of a diamond film, a diamond-like film, graphite, and combinations thereof.

9. The heat-dissipating device of Claim 1, **characterized in that** the semiconductor material is selected from the group consisting of bismuth telluride, lead telluride, boron carbide, silicon carbide, silicon germanium, silicon germanium carbide.

10. The heat-dissipating device of Claim 1, **characterized in that** the far infrared material is a far infrared ceramic.

11. The heat-dissipating device of Claim 1, **characterized in that** the layered functional unit further includes a coloring agent.
